# EUROPEAN PATENT APPLICATION

(11) **EP 2 293 331 A1**
(43) Date of publication of application: **09.03.2011**
(21) Application number: 10075362.3
(22) Date of filing: 23.08.2010
(51) Int. Cl.: H01L 27/02

(54) **Method for designing integrated electronic circuits having ESD protection and circuits obtained thereof**

(30) Priority: 27.08.2009 US 237545 P
(71) Applicant: IMEC, 3001 Leuven (BE)
(72) Inventor: Thijs, Steven, 2830 Willebroek (BE); Linten, Dimitri, 3190 Boortmeerbeek (BE)
(74) Representative: Clerix, André

(57) **Abstract**

A method for designing an integrated electronic circuit (1) having Electro Static Discharge (ESD) protection, the method comprising providing an integrated electronic circuit (1) having a predetermined performance during normal operation of the circuit, the integrated electronic circuit (1) comprising a power supply line (2) and at least one active device (4) protected by an ESD protection device (5), the active device (4) being powered from the power supply line (2), simulating an ESD event on the integrated electronic circuit (1) to determine if and where, during the ESD event, a parasitic ESD current path is created between the power supply line (2) and the at least one active device (4), and creating in thus determined parasitic ESD current path a circuit (6) to interrupt this parasitic ESD current path, at least during part of the ESD event.

## Description

### Field

The present disclosure relates to Electro Static Discharge (ESD) protection of integrated electronic circuits, in particular to the structure and layout of these integrated circuits to increase their ESD robustness.

### State of the art

During manufacturing or handling of electronic devices, such as integrated electronic circuits, electric charge may accumulate on tools, persons and/or the electronic device itself. This electric charge may result in undesired large voltage and/or current Electro Static Discharge (ESD) pulses being applied to the electronic device when discharging through this semiconductor device e.g. via its input terminal or via its power supply lines. These large pulses can cause failure of the semiconductor device for various reasons: dielectric breakdown, junction breakdown, breakage of conductors, heating of the device, etc.

Electro Static Discharge (ESD) protection devices are hence crucial to safe-guard a failure-proof operation of such electronic devices. These ESD protection devices are designed and arranged to bypass such ESD pulse to a power supply. Each ESD protection device is primarily characterized by is trigger voltage Vₜ, i.e. the voltage at which the ESD protection device starts conveying the ESD current and will switch to a low-resistance mode, its holding voltage Vₕ, i.e. the voltage over the ESD protection device when conveying the ESD current in its low-resistance mode, and its breakdown current I_{bd}, i.e. the maximum amount of current the ESD protection device can convey in this low-resistance mode before failure thereof, the latter parameter being a metric for the ESD robustness or the amount of ESD stress a ESD protection device can withstand.

Typically the ESD protection for the whole of the electronic device is provided by inserting an ESD protection device at one particular location whereby the ESD protection device is then designed sufficiently large to accommodate the expected ESD pulses. These ESD protection devices are then added at the terminals of the electronic device, e.g. at an input terminal to prevent incoming ESD pulses from entering in the electronic device, or e.g. between power supply lines to maintain a minimal power supply voltage.

If the ESD protection device has a substantial impact on the normal operation of the electronic device such that its predetermined performance is being jeopardized, a distributed approach can be applied. In this approach several ESD protection devices are provided throughout the electronic device whereby the dimensions and the distribution of these ESD protection devices over the electronic device is selected to provide the desired ESD protection with minimal impact on the device performance.

Even if an electronic device has acquired a sufficient ESD robustness by providing an appropriate set of ESD protection devices, the electronic device may still fail due to a slow response of an ESD protection device to the ESD event. In published European Patent Application EP 2 037 501 the response of an Diode Triggered Silicon-Controlled-Rectifier (DTSCR) ESD protection device is improved by providing a trigger component causing the SCR to respond faster upon triggering by an ESD event.

### Aim

The present disclosure aims to provide a method for designing an ESD protected integrated electronic circuit with an enhanced ESD protection performance without adversely affecting the performance of the circuit.

The present disclosure aims to provide integrated electronic circuits with ESD protection offering the desired circuit performance as well as the desired ESD protection performance.

### Summary

The present disclosure discloses integrated electronic circuits which overcome the problems of the prior art mentioned above.

An ESD protected integrated electronic circuit is disclosed, the circuit having a predetermined performance during normal operation thereof, the circuit comprising a power supply line, at least one functional device protected by an Electro Static Discharge (ESD) protection device whereby the ESD protection device is configured to bypass, during an ESD event, the corresponding current from the at least one functional device, the functional device being powered by the power supply line, and, an interrupting circuit configured to interrupt a parasitic ESD current path, between the power supply line and the at least one functional device, created during an ESD event.

The interrupting circuit comprises a turn-off device controlled by a timer circuit. This turn-off device is preferably a field effect transistor and the timer circuit is RC delay circuit with the resistor connecting the gate of the field effect transistor to the power supply line. This field effect transistor can be a functional device of the circuit or can purposively inserted in the parasitic ESD current path. In the latter case the dimensions of added the field effect transistor are selected to have no substantial impact on the predetermined performance of the circuit.

The interrupting circuit is designed to interrupt the parasitic ESD current path at least during the first part of the ESD event, i.e. from the onset of the ESD event. Preferably the interrupting circuit is designed to interrupt the parasitic ESD current until the ESD protection device has been triggered by the ESD event. Optionally the interrupting circuit is designed to interrupt the parasitic ESD current path during the whole of the ESD event.

A method for designing an integrated electronic circuit having Electro Static Discharge (ESD) protection is disclosed, the method comprising providing an integrated electronic circuit having a predetermined performance during normal operation thereof, the integrated electronic circuit comprising a power supply line and at least one functional device protected by an ESD protection device whereby the ESD protection device is configured to bypass, during an ESD event, the corresponding current from the at least functional device, the functional device being powered from the power supply line, determining a parasitic ESD current path between the power supply line and the at least one functional device, and creating in this parasitic ESD current path a circuit to interrupt the parasitic ESD current path, at least during the first part of the ESD event, i.e. from the onset of the ESD event.

The interrupting circuit can be created by providing an RC delay circuit to the gate of a field effect transistor already present in the parasitic ESD current path, the resistor of this RC delay circuit connecting the gate of the field effect transistor to the power supply line.

The interrupting circuit can be created by inserting, in the parasitic ESD current path, an additional field effect transistor and an RC delay circuit, the resistor of this RC delay circuit connecting the gate of the additional field effect transistor to the power supply line. The dimensions of the additional field effect transistor are selected to have no substantial impact on the predetermined performance of the integrated electronic circuit.

The interrupting circuit is configured to interrupt the parasitic ESD current path at least until the ESD protection device has been triggered by the ESD event. Preferably the interrupting circuit is configured to interrupt the parasitic ESD current path during the whole of the ESD event.

The parasitic ESD current paths can be determined by simulating an ESD event on the circuit to determine if and where, during the ESD event, a parasitic ESD current path is created between the power supply line and the at least one functional device.

### Brief description of the figures

Figure 1 shows a schematic of a prior art wideband Radio Frequency Low Noise Amplifier (RF LNA) with prior art dual diode ESD protection and a power clamp.

Figure 2 shows a schematic of a core LNA circuit with an ESD turn-off circuit according to an embodiment

Figure 3 shows the simulated ESD currents of an ESD protected LNA circuit when subjected to an VDD-to-IN 1 kV HBM ESD stress, with (a) and without (b) an ESD turn-off circuit according to an embodiment.

Figure 4 shows the measured normalized leakage current after different HBM stress levels for LNAs with and without turn-off circuitry according to an embodiment.

Figure 5 shows a schematic of the core of a prior art ESD protected LNA.

Figure 6 shows the LNA of figure 5 with an ESD turn-off circuit according to an embodiment.

Figure 7 shows a schematic of the core of a prior art ESD protected LNA circuit.

Figure 8 shows a schematic of the core of the ESD protected LNA circuit of figure 7 with an ESD turn-off circuit according to an embodiment.

Figure 9 shows a generic schematic of an ESD protected electronic circuit with turn-off circuit according to an embodiment

Figure 10 is a flow chart illustrating a method for designing an ESD protected electronic circuit with turn-off circuit according to an embodiment.

### Detailed description

The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present disclosure, the only relevant components of the device are A and B.

As discussed in the state-of-the-art section of this description the combination of ESD protection performance and circuit performance in a single electronic circuit is highly desirable, although not easy to achieve. This is certainly more pronounced for analogue circuits such as Radio Frequency (RF) circuits where the effective electrical and electronic parameters of all circuit elements, i.e. functional elements already present in the unprotected circuit as well as ESD protection devices only present in the ESD protected circuit, determine the final circuit performance. Measures to increase the overall ESD protection performance of the electronic circuit must have little or minimal impact on the predetermined performance of the electronic circuit during normal operation, i.e. when the ESD protection devices are not operative.

When designing the ESD protection of an electronic circuit, the effective values of parameters of the selected ESD protection devices, such as ESD trigger voltages Vₜ and ESD breakdown current I_{bd}, are determined in view of the desired ESD protection while the dimensions of these ESD protection devices are also determined in view of their contribution to the circuit performance in normal operation.

Even if these ESD parameters are appropriately selected, the ESD protected electronic circuit may still fail if the response of an ESD protection device to an ESD event is too slow. Although the ESD protection device may be triggered by an ESD event, it may take some time before the ESD protection device is capable of conveying all unwanted currents towards the power supply lines. These unwanted currents can result from parasitic ESD current paths created by the ESD event between the functional element to be protected by the ESD protection device and the power supply line.

For the purpose of teaching an Radio Frequency Wide Band Low Noise Amplifier (RF WB LNA) is used, although the embodiments can be applied to other electronic circuits having ESD protection.

The ESD protection of such a RF WB LNA (LNA) is a challenge for both RF and ESD protection designers. Typically, the parasitic capacitance of the added ESD protection devices limits the performance of the RF design. Several solutions have been proposed in the recent years to cope with this capacitive load in a wideband RF LNA design, going from distributed ESD protection, bootstrapping, to the use of symmetric T-diodes. So far, these solutions occupy a large silicon real-estate, which translates in an increased cost in advanced CMOS technologies.

The thin gate dielectrics used in advanced CMOS technology makes the LNA's RF input very sensitive to ESD stress events. Even with good ESD protection devices, additional precautions need to be taken to prevent gate oxide failure and possible triggering of parasitic ESD current paths during an ESD event. The latter is easily overlooked.

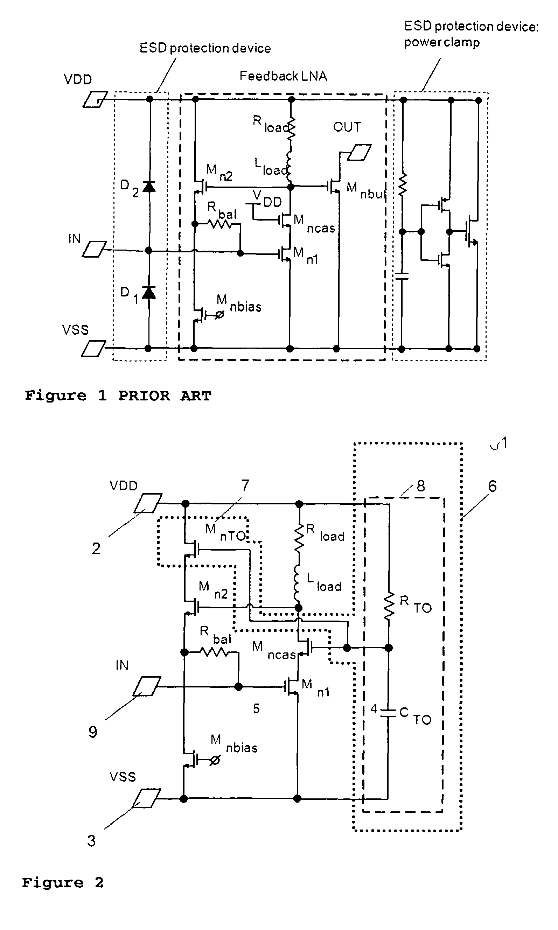

The LNA, as shown in figure 1, is an active feedback, common source amplifier. A cascode stage Mₙ₁-M_{ncas} offers gain, while the feedback via the source-follower Mₙ₂ and R_{bal} ensures input matching. A 30x30 µm2 multilayer 0.9 nH shunt peaking inductor L_{load} is added in series with the load resistor R_{load} to boost the bandwidth. The second stage M_{nbuf} works as a buffer to drive the measurement setup used the measure the performance of the ESD protected circuit. The LNA consumes 12.36 mW power with a 1.2 V supply.

As shown in figure 1, an ESD protection containing two diodes D1, D2 as ESD protection devices for the functional element Mₙ₁ and a power clamp between the two power supply lines VDD and VSS, is commonly used as a low-capacitance RF ESD protection solution. The diodes D1 and D2 are provided between the input terminal IN and respectively the low power supply line VSS and the high power supply line VDD, When designing the RF WB LNA, the bandwidth of the RF circuit is traded off with the ESD robustness, i.e. the maximum ESD current that the ESD protection device can convey. Larger diodes D1, D2 provide intrinsically a higher ESD robustness and a lower on-resistance during an ESD event, but result in a large parasitic capacitive load at the RF input jeopardizing e.g. the matching impedance of the LNA.

For this LNA topology, two worst case ESD stress conditions exist: the input terminal IN is positive biased with respect to the low power supply voltage line VSS IN(positive)-to-VSS(negative) stress, and the high power supply line VDD is positive biased with respect to the input terminal IN VDD(positive)-to-IN(negative).

All diodes in figure 1 are 40 µm wide with 50 fF parasitic capacitance and with 3.2 kV Human Body Model robustness. An RC triggered NMOS is selected as a power clamp to the LNA circuit.

As discussed above, the core LNA fails early in the VDD-IN stress combination but also in a VDD-VSS stress combination as a result from triggering of parasitic ESD current paths in the core of the LNA. These parasitic ESD current paths do not occur during normal operation of the ESD protected electronic circuit. In case an additional redesign of the R_{bal} resistor is not an option from RF point of view, an alternative methodology to boost the ESD robustness is to keep the parasitic ESD current path off, at least during part of an ESD event, by means of an ESD turn-off circuit.

The addition of such turn-off circuits is a general strategy to keep any parasitic ESD current path off at least during part of the ESD event. Possible triggering of parasitic ESD current paths during ESD events is easily overlooked when determining the ESD performance of an ESD protected electronic circuit. In fact, due to such effects, failure of functional elements can occur well before gate-oxide breakdown, as demonstrated in the previous paragraphs. When stressing VDD to IN, the feedback transistor Mₙ₂ is pulled open resulting in a parasitic ESD current path towards the transistor Mₙ₁ and R_{bal} will fail during this ESD event.

To turn the parasitic ESD current path through the existing functional transistor Mₙ₂ **4** off, a turn-off device **6** in the form of an additional transistor M_{nTO} **7** is added at the drain of Mₙ₂ **4** inside this parasitic ESD current path. The gate of this additional transistor M_{nTO} **7** is connected to an ESD transient RC turn-off timer **8** R_{TO}-C_{TO}, as shown in figure 2. This way an interrupt circuit **6,** shown in figure 2 by the dotted line, comprising a transistor **7** having an RC circuit **8** connected to its gate whereby the resistor connected to the high power supply line VDD **2,** is inserted in a parasitic ESD current path. In this figure 2 the core LNA **1** is shown without the ESD protection devices and the power clamps. During normal operation conditions of the ESD protected LNA circuit, the gate of M_{nTO} **7** is pulled to VDD **2** via the resistor R_{TO} causing the transistor M_{nTO} **7** to fully conduct. Hence the transistor M_{nTO} **7** does not impact the normal RF circuit operation of the ESD protected LNA circuit **1.** During an ESD event between the high power supply line VDD **2** on the one hand and, the input terminal IN **9** or the low power supply VSS **3,** on the other hand, the additional transistor M_{nTO} **7** is kept off for the initial first nanoseconds of the ESD event, the duration depending on the RC time constant, thereby forcing the corresponding ESD current to flow through the power clamp **5,** instead of through the parasitic ESD current path.

The time constant of the RC circuit **8** R_{TO}-C_{TO} is selected in view of the speed at which the ESD protection device **5** can start conveying the ESD current. This response time is a characteristic of the ESD protection device **5** and can to some extent be tuned, e.g. in the case of the DTSCR. The time constant is selected to at least turn off a transistor **7** in the parasitic ESD current path until an ESD protection device **5** is triggered to a low-resistance state sufficiently for draining the ESD current to a power supply line **2,3.** This time constant of the turn-off circuit **8** can be selected such that the parasitic ESD current path is turned during at least a part of the ESD event. However this time constant can be selected to turn off the parasitic ESD current path during the whole duration of the ESD event.

If several parasitic ESD current paths are created during an ESD event, in each of these parasitic ESD current paths a transistor **7** having an RC circuit **8** to its gate can be inserted. The RC circuit of the turn-off circuits **8** can be shared to turn off several possible parasitic ESD paths with the same time constant.

In figure 2 the cascode transistor M_{ncas} is also turned off during stress between VDD and VSS, to prevent failure caused by source-drain filamentation. The timer circuit R_{TO}-C_{TO} is also connected to the gate of the cascade transistor.

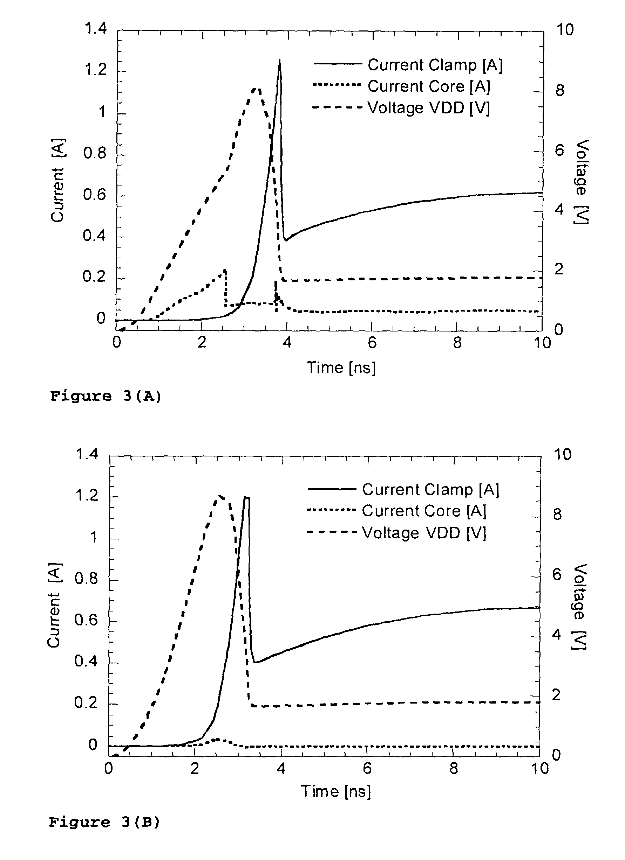

Figure 3 shows the simulated voltage and current waveforms during a 1kV Human Body Model VDD-to-IN stress, on the LNA with dual-diode D₁, D₂ ESD protection and an RC-triggered NMOS as power clamp. These 1kV HBM simulations showed that at 3ns, the voltage at the high power supply line VDD **2** snaps back, indicating turn-on of the power clamp **5,** whereby a current peak is seen for the current through the power clamp **5.** However, during the first 2ns, already 250mA flows through the core circuit **4,** which could cause failure of the core LNA **4.** The situation gets worse when the ESD response time of the power clamp **5** is further reduced. When adding the turn-off circuit **6** with a turn-off device **7** controlled by a timer circuit **8** M_{nTO}-R_{TO}-C_{TO}, the ESD current, normally pushed through the core LNA **4** via parasitic ESD current paths when the power clamp **5** is not yet fully turned on, is reduced from 250mA peak to 20mA peak, preventing early failure of the core LNA **4** at higher ESD stress levels.

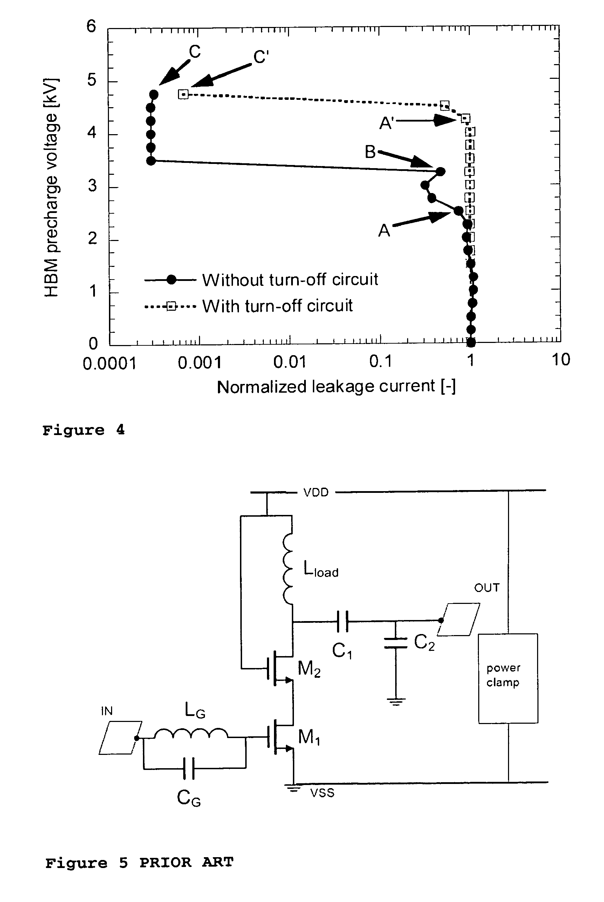

HBM measurements, whereby the stress voltage was increased in 250V voltage steps, have been performed on the LNA where a RC-triggered NMOS **5** was used as power clamp, and with the shared turn-off circuit **8** as shown in figure 2. The turn-off timer **8** R_{TO}-C_{TO} was constructed with a 20kΩ resistor and a 25pF capacitor, yielding an RC time constant of 500ns. Due to addition of the turn-off circuit **6,** the HBM robustness was increased from 2.25kV to 4kV. The measured normalized leakage current evolution after each HBM level step is compared in figure 4 for the ESD protected LNA circuit with (open squares) and without (solid diamonds) turn-off circuit **6.** Markers are included to indicate the different failure points. Without turn-off circuit b6, a leakage current decrease is seen at 2.5kV (point A), caused by the resistance increase of Rbal. This effect occurs at 4kV when the turn-off circuit **6** is used (point A'). When increasing the HBM level on the ESD protected LNA circuit without turn-off circuit, Rbal fuses to an open at 3.25kV (point B) resulting in another leakage decrease. Finally, at a HBM level of 4.75kV, a Tcoil inductor, provided to compensate the parasitic capacitance of a local clamp, fuses in both cases (points C and C'), which was observed by visual inspection. The gain in ESD performance by adding a turn-off circuit **6** to interrupt parasitic ESD current paths created during an ESD event is the increase in HBM voltage from point A to A' in figure 4.

When using only the turn-off circuit **6,** without local clamping and in absence of R_{bal}, an HBM robustness of 3.5kV was measured. In this configuration the HBM robustness was limited by failure of the feedback transistor Mₙ₂ of figure 1 as discussed in previous paragraphs. In case this protection level is sufficient, it is better to use the turn-off solution instead of local clamping. Local clamping puts a capacitive loading on the RF input terminal IN, which parasitic capacitance needs to be compensated by an additional T-coil while the turn-off solution comes almost for free.

When decreasing the RC-time constant of the turn-off timer **8** from 500ns to 200ns and 20ns respectively, no ESD performance degradation is noticed, indicating that the turn-off circuit **8** is only needed during the first ns, defined by the turn-on time or response time of the power clamp **5.** This corresponds with the simulations in figure 3. In case of ESD stress between VDD+ **2** and VSS- **3,** failure was observed in transistor Mₙ₁ **4** due to a parasitic ESD current path through the core LNA **4** at 3kV HBM stress. By addition of the local clamping, the robustness was increased to 4.75kV. The turn-off circuit **6** was also connected to the gate of cascode transistor M_{ncas}, as shown in figure 2. This results in an increased performance between VDD+ and VSS- up to 7kV.

An overview of the HBM measurements on the different circuit variations discussed above for the weakest pin combinations VDD+ to IN- and VDD+ to VSS- is shown in Table 1 below.

**Table 1: Impact of turn-off circuit on On-wafer HBM measurements [kV]**

| time constant Turn-off circuit | | | HBM (kV) | HBM (kV) |
|---|---|---|---|---|
| 500ns | 200ns | 20ns | VDD-IN ESD stress | VDD-VSS ESD stress |
| - | - | - | 1.5 | 3 |
| X | - | - | 3.75 | 6.5 |
| - | X | - | 3.75 | - |
| - | - | X | 3.75 | - |

Finally, the RF design with the turn-off circuitry was tested for system-level ESD stress using an on-wafer Human Metal Model tester which tests the ESD robustness of the system containing the ESD protected circuit. It is important to point out that most RF circuits can not tolerate additional off-chip ESD protection against system level ESD based on a Transient Voltage Suppressor and a current limiting resistor as the associated impedance of this off-chip ESD protection jeopardize the normal operation of the circuit incorporated in the system. The LNA design having the turn-off circuit **6** as discussed above could withstand at least 1kV HMM for all possible pin-to-pin combinations even without additional system level ESD protection.

Figure 5 shows the core of another ESD protected LNA circuit with cascade configuration. The core of this circuit contains a cascode transistor pair M1 and M₂. The gate of transistor M1 is connected to the input terminal IN via an L_{G}-C_{G} parallel circuit providing impedance matching. The load capacitor L_{load} determines the resonance peak of this narrow band RF circuit. The capacitive divider C₁-C₂ at the output terminal OUT provides output matching. In this LNA a parasitic ESD current path through the LNA core will be created when the high power supply VDD is stressed with respect to the low power supply VSS (VDD+ VSS-). When this ESD event occurs, the transistor M₂, connected with its gate to the high power supply line VDD, will start to conduct and a parasitic ESD current path is created towards the functional transistor M₁.

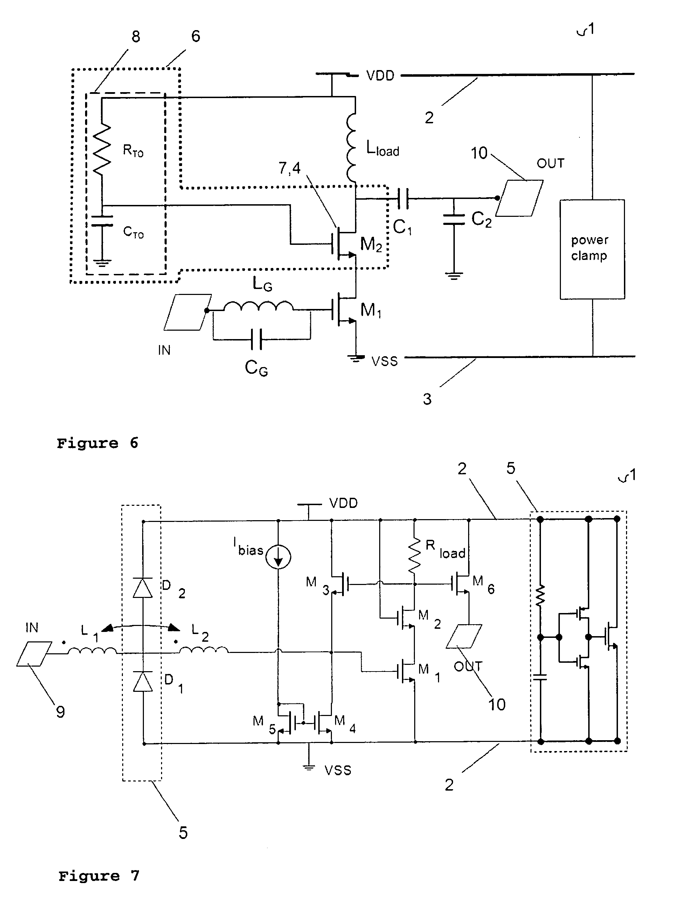

Like in the previous paragraphs, this parasitic ESD current path can be interrupted at least during part of the ESD event by creating a turn-off circuit **6** in this parasitic ESD current path as shown in figure 6. Whereas in the embodiment illustrated by figure 2 an additional transistor M_{nTO} **7** was inserted in the parasitic ESD current path to allow interrupting this parasitic ESD current path, here an active functional device **4,** i.e. transistor M₂, will be turned off by the RC circuit **8** to interrupt the parasitic ESD current path. In the embodiment illustrated by figure 6 the turn-off circuit **6** is formed by the transistor M₂ being part of the core of the LNA and operative during normal operation of the LNA and the additional timer circuit **8** R_{TO}-C_{TO}. During normal operation, the gate of M₂ is biased to VDD **2** and hence behaves as without the additional R and C. The presence of the turn-off circuit **6** has not impact on the normal operation of the LNA circuit.

During an ESD event between VDD+ **2** VSS- **3 ,** the gate of M₂ needs some time to get powered up because of the RC circuit **8** added to its gate. Therefore, during the first part of the ESD event starting from the onset of the ESD event, the parasitic ESD current path through the core of the LNA circuit is interrupted as the transistor M₂ is turned off. An ESD power clamp **5** between the high power supply line VDD **2** and the low power supply line VSS **3** will have sufficient time to turn-on when being triggered by the ESD event. Hence this power clamp **5** will be fully conducting when the parasitic ESD current path through the core **4** is finally turned on. Thanks to this ESD turn-off circuit **6,** the overall ESD robustness level of the LNA circuit **1** will be greatly increased.

Figure 7 shows the core **4** of another ESD protected LNA circuit **1** with cascade configuration. The core of the circuit contains a cascode transistor pair M₁ and M₂ connected to an output buffer M6 which is added to drive the measurement equipment used to the test the performance of the circuit. A load resistor R_{load} is added to provide a wide band operation. A feedback circuit is provided via the feedback transistor M₃. A current mirror M₄-M₅, biased via a current source I_{bias}, determines the operation point of this feedback transistor M₃. At the input terminal IN coils L₁ and L₂ are added to compensate for parasitic impedance thereby providing impedance matching. Two diodes D₁ and D₂ are connected between the input line and respectively the low power supply line VSS **3** and the high power supply line VDD **2** as ESD protection devices **5** of the active functional device M₁ **4.** A power clamp is connected to the power supply lines VDD **2** and VSS **3.** In this LNA circuit **1** a parasitic ESD current path through the LNA core **4** will be created when the high power supply VDD **2** is stressed with respect the input terminal IN **9.** Upon this VDD+ **2** IN- **9** ESD event the feedback transistor M₃, which is connected to the high power supply line VDD via the load resistor R_{load}, will turn on whereby a parasitic ESD current flows in the core of the LNA circuit. As the gate of the feedback transistor M₃ is an RF point, i.e. part of the signal path through the LNA circuit, no additional parasitic impedance is allowed here. Hence one can not add a timer circuit **8** R_{TO}-C_{TO} to this gate for turning the transistor M₃ at least during part of the ESD event thereby interrupting the parasitic ESD current path.

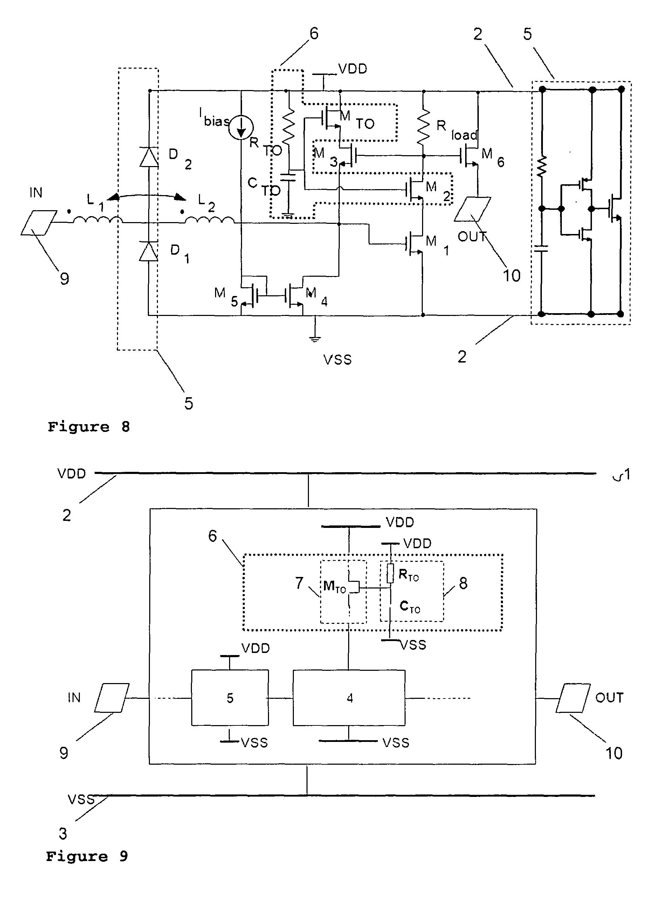

A solution is shown in figure 8. As was the case in the embodiment illustrated by figure 2, an additional small transistor M_{turnoff} **7** is inserted in the parasitic ESD current path formed by transistor M₃ during the ESD event. In the embodiment illustrated by figure 8 the additional transistor **7** is placed in between the drain of the functional transistor M₃ **4** and the high power supply line VDD **2,** such that the transistor M₃ **4** is in between the additional transistor **7** and the RF point. To the gate of this additional transistor M_{turnoff} **7** a timer circuit **8** R_{turnoff}-C_{turnoff} is connected. The additional transistor M_{turnoff} **7** is dimensioned to have no or minimal impact on the normal operation of the LNA circuit **1.** During normal operation the gate of this additional transistor M_{turnoff} **7** is connected via the resistor R_{turnoff} to the high power supply line VDD **2** and the additional transistor M_{turnoff} **7** is switched on such that the current path through transistor M3 is not interrupted.

In the LNA circuit **1** illustrated by figure 7 a second parasitic ESD current path can be created in case an ESD event occurs whereby the high power supply line VDD **2** is stressed with respect to the low power supply line VSS b3 (VDD+VSS-). During this ESD event the transistor M₂ **4** can be switched on as its gate is connected to the high power supply line VDD **2** and a parasitic ESD current can flow through the core **4** of the LNA circuit **1.** Like in the embodiment illustrated by figure 6 this functional transistor M₂ **4** can be switched off by a timer circuit **8** at least during part of the ESD event. One can choose to insert a dedicated RC circuit **8** to the gate of M₂ or, as already mentioned in a previous paragraph, use the timer circuit R_{turnoff}-C_{turnoff} **8** of the additional transistor M_{turnoff} **7** to temporarily switch off the transistor M₂ **4** thereby interrupting also the second parasitic ESD current path. The latter option is shown in figure 8.

In the ESD protected circuits as disclosed turn-off circuitry **6** is provided to interrupt parasitic ESD current paths created during an ESD event thereby improving the overall ESD performance of the circuit **1.** The additional turn-off circuitry **6** prevented parasitic ESD currents path in the core circuit **4** to be triggered during the ESD event. These parasitic ESD current paths are current paths that are operative during normal operation of the ESD-protected circuit, but should not conduct current because of an ESD event. As discussed above, depending on the layout and the topology of the ESD-protected circuit **1** one or more of the active functional devices **4** of this circuit can however be biased due to the ESD event to the extent that these active functional devices will conduct also during the ESD event. As the ESD protection device **5,** which is provided to bypass ESD current from the functional device(s) of the circuit, has a limited response time, the ESD current needs either to be conveyed via another route or interrupted before reaching the functional device 4. In this disclosure a functional device **4** is a device that is also present in the ESD unprotected circuit. This functional device **4** can be a passive device such as a coil or resistor. It can also be an active device such as diode or transistor.

Figure 9 shows as generic schematic of an ESD protected circuit **1** with a turn-off circuitry **6** according to this disclosure. The circuit is powered by a high power supply line VDD **2** and a low power supply line VSS **3.** The circuit **1** has an input terminal IN **9** and an output terminal OUT **10.** The circuit **1** comprises at least one functional device **4,** either passive or active. At least one of these functional devices **4** is protected by one more ESD protection devices **5** configured to bypass during an ESD event the corresponding ESD current to a power supply line. In the parasitic ESD current path between a power supply line **2,3** and the ESD protected functional device a turn-off circuit is provided configured to interrupt, at least during the initial part of the ESD event, this parasitic ESD current path thereby allowing the ESD protection device **5** to be fully triggered by the ESD event. This turn-off circuit **6** comprises a turn-off device **7,** which can interrupt the parasitic ESD current path, and a timer circuit **8** controlling the operation of this turn-off device **7.** Preferably the turn-off device **7** is a transistor either already present as a functional device or purposively added as turn-off device. Preferably the timer circuit **8** is an RC delay circuit with the resistor connected to the gate of the transistor used as turn-off device and the power supply.

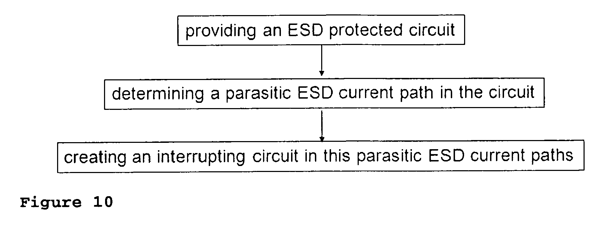

Figure 10 is a flow chart illustrating a method for designing an ESD protected circuit **1** having an interrupt or turn-off circuit **6** as disclosed in the foregoing paragraphs and illustrated in figure 9. The method comprises providing an ESD protected circuit **1,** determining in this ESD protected circuit **1** at least one parasitic current path and creating in this at least one parasitic current path an interrupt circuit **6.**

## Claims

1. An ESD protected integrated electronic circuit (1) having a predetermined performance during normal operation thereof, the circuit comprising:
a power supply line (2),
at least one functional device (4) protected by an Electro Static Discharge (ESD) protection device (5) whereby the ESD protection device (5) is configured to bypass, during an ESD event, the corresponding current from the at least one functional device (4),
the functional device (4) being powered by the power supply line (2), and,
an interrupting circuit (6) configured to interrupt a parasitic ESD current path, between the power supply line (2,3) and the at least one functional device (4), created during an ESD event.

2. The circuit of claim 1, wherein:
the interrupting circuit (6) comprises a turn-off device (7) controlled by a timer circuit (8).

3. The circuit of claim 2, wherein:
the turn-off device (7) is a field effect transistor and
the timer circuit (8) is RC delay circuit with the resistor connecting the gate of the field effect transistor to the power supply line.

4. The circuit of claim 3, wherein:
the field effect transistor is a functional device (4) of the circuit.

5. The circuit of claim 3, wherein:
the field effect transistor is not a functional device of the circuit.

6. The circuit of claim 5, wherein:
the dimensions of the field effect transistor are selected to have no substantial impact on the predetermined performance of the circuit.

7. The circuit according to any of the foregoing claims wherein:
the interrupting circuit (6) is designed to interrupt the parasitic ESD current path at least from the onset of the ESD event.

8. The method according to claim 7, wherein:
the interrupting circuit (6) is designed to interrupt the parasitic ESD current until the ESD protection device (5) has been triggered by the ESD event.

9. The integrated electronic circuit of claim 8, wherein:
the interrupting circuit (8) is designed to interrupt the parasitic ESD current path during the whole of the ESD event.

10. A method for designing an integrated electronic circuit (1) having Electro Static Discharge (ESD) protection, the method comprising:
providing an integrated electronic circuit (1) having a predetermined performance during normal operation thereof,
the integrated electronic circuit (1) comprising a power supply line (2) and at least one functional device (4) protected by an ESD protection device (5) whereby the ESD protection device (5) is configured to bypass, during an ESD event, the corresponding current from the at least functional device (4),
the functional device (4) being powered from the power supply line (2),
determining a parasitic ESD current path between the power supply line (2) and the at least one functional device (4), and
creating in this parasitic ESD current path a circuit (6) to interrupt the parasitic ESD current path, at least from the onset of the ESD event.

11. The method according to claim 10, wherein:
the interrupting circuit (6) is created by providing an RC delay circuit (8) to the gate of a field effect transistor already present in the parasitic ESD current path, the resistor of this RC delay circuit (8) connecting the gate of the field effect transistor to the power supply line (2).

12. The method according to claim 10, wherein:
the interrupting circuit (8) is created by inserting, in the parasitic ESD current path, an additional field effect transistor (7) and an RC delay circuit (8), the resistor of this RC delay circuit (8) connecting the gate of the additional field effect transistor (7) to the power supply line (2).

13. The method according to claim 12, wherein:
the dimensions of the additional field effect transistor (7) are selected to have no substantial impact on the predetermined performance of the integrated electronic circuit (1).

14. The method according to any of the claims 10 to 13 wherein:
the interrupting circuit (6) is designed to interrupt the parasitic ESD current path at least until the ESD protection device has been triggered by the ESD event.

15. The method according to claim 14, wherein:
the interrupting circuit (6) is designed to interrupt the parasitic ESD current path during the whole of the ESD event.

16. The method according to any of the claims 10 to 15, wherein:
determining the parasitic ESD current path comprises simulating an ESD event on the circuit (1) to determine if and where, during the ESD event, a parasitic ESD current path is created between the power supply line (2) and the at least one functional device (4).
